# EUROPÄISCHE PATENTSCHRIFT

(11) **EP 3 844 803 B1**
(45) Veröffentlichungstag und Bekanntmachung des Hinweises auf die Patenterteilung: **26.10.2022**
(21) Anmeldenummer: 19762106.3
(22) Anmeldetag: 23.08.2019
(51) Int. Cl.: H01L 21/677, H01L 21/67, H05K 13/04, H01L 21/68, H05K 13/00

(54) **INSPEKTION BEIM ÜBERTRAGEN ELEKTRONISCHER BAUTEILE VON EINEM ERSTEN ZU EINEM ZWEITEN TRÄGER**
INSPECTION DURING TRANSFER OF ELECTRONIC COMPONENTS FROM A FIRST TO A SECOND CARRIER
INSPECTION PENDANT LE TRANSFERT DE COMPOSANTS ÉLECTRONIQUES D'UN PREMIER SUPPORT VERS UN DEUXIÈME

(30) Priorität: 27.08.2018 DE 102018006760
(43) Veröffentlichungstag der Anmeldung: 07.07.2021
(73) Patentinhaber: Muehlbauer GmbH & Co. KG, 93426 Roding (DE)
(72) Erfinder: SCHMID, Konrad, 93185 Michelsneukirchen (DE); PRAKAPENKA, Uladimir, 93426 Roding (DE)
(74) Vertreter: Schmidt, Steffen J.
(86) Internationale Anmeldenummer: PCT/EP2019/072577
(87) Internationale Veröffentlichungsnummer: WO 2020/043612

(56) Entgegenhaltungen:
- WO-A1-02/054480
- DE-A1-102008 018 586
- DE-A1-102010 053 912
- DE-A1-102011 104 225
- DE-A1-102015 013 495
- JP-A- 2003 124 700
- US-A1- 2009 187 354
- US-B1- 7 042 580

## Beschreibung

### Hintergrund

Hier werden eine Inspektion beim Übertragen elektronischer Bauteile von einem ersten Träger zu einem zweiten Träger und eine Vorrichtung und ein Verfahren zum Aufbringen von Klebstoff auf den zweiten Träger beschrieben. Insbesondere werden eine Vorrichtung und ein Verfahren beschrieben, um (vorher oder nachher) zu inspizieren, wenn ein elektronisches Bauteil von dem ersten Träger getrennt und direkt auf den zweiten Träger übertragen wird, (vor oder nachdem) nachdem Klebstoff auf den zweiten Träger aufgebracht wurde.

Beim Übertragen von elektronischen Bauteilen, insbesondere Chips (engl.: "dies") und insbesondere beim Übertragen von vereinzelten elektronischen Bauteilen besteht allgemein das Problem, dass diese leicht beschädigt werden können und daher mit großer Sorgfalt behandelt werden müssen. Zudem sind elektronische Bauteile einer kontinuierlichen Miniaturisierung unterworfen, so dass die Anforderungen hinsichtlich der Genauigkeit beim Übertragen der elektronischen Bauteile kontinuierlich steigen.

Die WO2017/076989 A1 betrifft ein Verarbeitungssystem und Verfahren zur Verarbeitung eines flexiblen Substrats, zum Beispiel einer Bahn unter Verwendung eines Spanners mit einer entlang einer Transportrichtung des flexiblen Substrats bewegbaren Vakuumplatte mit einem Indexierer, der das flexible Substrat intermittierend zur Verarbeitung bewegt. Die Vakuumplatte ist konfiguriert, um entlang der Transportrichtung bewegt zu werden. Ein Indexierer ist konfiguriert, um intermittierend das flexible Substrat zur Verarbeitung zu bewegen. Eine Steuerung ist konfiguriert, den Spanner und den Indexierer so zu steuern, dass eine Relativgeschwindigkeit zwischen dem Indexierer und die Unterdruckplatte des Spanners unter allen Arbeitsbedingungen oberhalb einer vorgegebenen Schwelle gehalten wird, auch wenn das flexible Substrat angehalten wird. Die Bahn, die in dem Verarbeitungssystem verwendet werden kann, weist eine Anzahl von elektrischen Strukturen auf, die durch einen Abstand voneinander getrennt sind. Bei diesen elektrischen Strukturen kann es sich um jede Art von flexibler Elektronik handeln.

Die DE 10 2011 104 225 B4 betrifft ein Vorrichtung zum Positionieren zu übertragender elektronischer Bauteile relativ zu einer Ausstoßeinrichtung, mit der Ausstoßeinrichtung, die einen Schieber für zumindest ein elektronisches Bauteil und ein den Schieber umgebendes Gehäuse aufweist, wobei das Gehäuse einen ersten lichtdurchlässigen Bereich aufweist. Ein erster Träger stellt die zu übertragenden elektronischen Bauteile bereit. Der erste Träger hat eine der Ausstoßeinrichtung zugewandte erste Seite und eine von der Ausstoßeinrichtung abgewandte zweite Seite. Auf der zweiten Seite ist eine Vielzahl der elektronischen Bauteile vorgesehen. Eine Bilddatenerfassungseinrichtung ist dazu eingerichtet, durch den ersten licht-durchlässigen Bereich des Gehäuses hindurch Bilddaten einer Region zu erfassen, in der der Schieber mit dem wenigstens einen elektronischen Bauteil zu interagieren eingerichtet ist. Eine Steuerung ist dazu eingerichtet, aus den erfassten Bilddaten Positionsdaten des zu übertragenden elektronischen Bauteils zu ermitteln sowie aufgrund der Positionsdaten Steuerbefehle zu erzeugen. Zumindest ein Aktor ist dazu eingerichtet, den ersten Träger und die Ausstoßeinrichtung aufgrund der Steuerbefehle relativ zueinander zu bewegen, um einen Versatz zwischen einer Längsachse des Schiebers und einer Mittelachse des zu übertragenden elektronischen Bauteils zu verändern, wobei die Ausstoßeinrichtung einen im Inneren des Gehäuses angeordneten ersten Spiegel umfasst.

Die DE 103 49 847 B3 betrifft eine Positioniervorrichtung und ein Positionierverfahren für die Übertragung elektronischer Bauteile beschrieben. Dabei ist ein auf einer Trägerfolie angeordneter Halbleiter-Wafer oberhalb und parallel zu einem bandartigen Substrat angeordnet. Der Wafer kann mittels einer Waferhalterung innerhalb der Waferebene verschoben und zusätzlich um eine senkrecht zu der Waferebene stehende Rotationsachse gedreht werden. Eine Ausstoßeinrichtung umfasst eine Ausstechnadel, die mittels einer Bewegung nach unten auf die Rückseite eines abzulösenden Chips wirkt und diesen von der Trägerfolie ablöst. Der von der Trägerfolie abgelöste Chip wird dadurch auf eine Bondposition auf dem bandartigen Substrat abgelegt.

Die JP 2003-109979 A betrifft eine Vorrichtung mit zumindest zwei Schiebern zum Heraustrennen von Bauteilen aus einem ersten Träger. Dabei werden die Bauteile jeweils von einer Saug-Pipette eines Übertragungselements aufgenommen. In einem letzten Schritt wird das Übertragungselement samt Saug-Pipetten und Bauteilen über einen zweiten Träger positioniert, welcher bereits mit Haftmittel präpariert wurde, und die Bauteile auf den zweiten Träger abgelegt. Dabei werden die Bauteile nicht direkt vom ersten Träger zum zweiten Träger übertragen, sondern nach der Abtrennung vom ersten Träger mittels eines Übertragungselements aufgenommen, und in einem Folgeschritt durch das Übertragungselement genau orientiert und auf den zweiten Träger befestigt.

Das Dokument US 7 042 580 B1 betrifft eine Vorrichtung zur optischen Vermessung elektronischer Bauteile, die in eine Prozessstation integriert sein kann. Die Vorrichtung ist hierbei von der Prozessstation physisch beabstandet jedoch elektronisch mit dieser gekoppelt. Die Vorrichtung zur optischen Vermessung elektronischer Bauteile umfasst einen auf einen Messbereich gerichteten Kamerasensor, der mit Hilfe einer Fördereinrichtung bewegt werden kann.

Das Dokument DE 10 2015 013 495 A1 offenbart eine Vorrichtung zum Übertragen elektronischer Bauteile von einem Wafer zu einem Träger, wobei die elektronischen Bauteile während des Übertragungsprozesses aus verschiedenen Richtungen mit optisch erfassenden Sensoren inspiziert werden.

Das Dokument DE 10 2011 104 225 A1 offenbart eine Vorrichtung zum Positionieren zu übertragender elektronischer Bauteile relativ zu einer Ausstoßeinrichtung. Dabei weist die Ausstoßeinrichtung einen Schieber für zumindest ein elektronisches Bauteil und ein den Schieber umgebendes Gehäuse auf, wobei das Gehäuse einen ersten lichtdurchlässigen Bereich aufweist. Die zu übertragenden elektronischen Bauteile werden durch einen ersten Träger, der eine der Ausstoßeinrichtung zugewandte erste Seite und eine von der Ausstoßeinrichtung abgewandte zweite Seite umfasst, bereitgestellt, wobei auf der zweiten Seite eine Vielzahl der elektronischen Bauteile vorgesehen ist. Zumindest eine Bilddatenerfassungseinrichtung ist hierbei dazu eingerichtet, durch den ersten lichtdurchlässigen Bereich des Gehäuses hindurch Bilddaten einer Region zu erfassen, in der der Schieber mit dem wenigstens einen elektronischen Bauteil zu interagieren eingerichtet ist. Eine Steuerung ist dazu eingerichtet, aus den erfassten Bilddaten Positionsdaten des zu übertragenden elektronischen Bauteils zu ermitteln sowie aufgrund der Positionsdaten Steuerbefehle zu erzeugen; und zumindest ein Aktor ist dazu eingerichtet, den ersten Träger und die Ausstoßeinrichtung aufgrund der Steuerbefehle relativ zueinander zu bewegen, um einen Versatz zwischen einer Längsachse des Schiebers und einer Mittelachse des zu übertragenden elektronischen Bauteils zu verändern

Weitere Vorrichtungen und Verfahren zum Übertragen von elektronischen Bauteilen, die technologischen Hintergrund zur hier beschrieben Vorrichtung und zum hier beschriebenen Verfahren bilden, werden in JP 5267451 A, EP 0 565 781 B1 und DE 198 22 512 A1, US 4,667,402 B1, US 2008/0086874 A1, EP 2 764 826 A1, US 2002/0019074 A1, US 2009/ 242124 A1, EP 0 140 126 A1, US 4,990,051 B1, US 2006/237142 A1, US 2007/293022 A1, US 6,201,306 B1, JP 2009-238881 A, JP 2010-161155 A, JP 60-097634 A, JP 01-109737 A, JP 55-070041 A, JP 2002-050670 A, JP 09-162204 A, JP 53-100765 A, JP 2008-004936 A, WO 2007/137888 A1, WO 2000/014789 A1, EP 949 662 A2, US 2006/013680 A1, US 2016/308269 A1, DE 10 2011 017218 A1, EP 2 491 583 B1 beschrieben.

### Problem

Vor diesem Hintergrund werden eine Anordnung und eine Vorgehensweise benötigt, mit der der Durchsatz beim Übertragen der Bauteile von dem ersten auf den zweiten Träger mit einer hohen Genauigkeit und Wiederholbarkeit zu steigern ist. Außerdem sollen auch wenig bis gar nicht transparente zweite Träger ohne Qualitätseinbußen bei der Lage-Genauigkeit der Bauteil-Ablage verwendbar sein. Schließlich sollen die Bauteile schonend behandelt werden.

### Vorgeschlagene Lösung

Zur Lösung dieser Aufgabe wird eine Vorrichtung zum Übertragen elektronischer Bauteile von einem ersten Träger zu einem zweiten Träger vorgeschlagen, wobei
- der erste Träger eine Vielzahl vereinzelter Bauteile von ihm lösbar trägt, und
- der zweite Träger quasi-endlos ausgestaltet ist und in seiner in seiner Längs- und Quererstreckung eine Vielzahl elektronischer Teilbaugruppen trägt, zu denen jeweils eines der Bauteile von dem ersten Träger zu übertragen ist, und wobei
die Vorrichtung umfasst:
- eine erste Aufnahme, die dazu eingerichtet ist, den ersten Träger aufzunehmen;
- eine zweite Aufnahme, die dazu eingerichtet ist, dass über sie der zweite Träger entlang seiner Längserstreckung in einer Förderrichtung des zweiten Trägers zu führen ist; wobei
- die erste Aufnahme dazu eingerichtet ist, den ersten Träger so aufzunehmen, dass die von ihm getragenen Bauteile zu der zweiten Aufnahme hin orientiert sind;
- eine Trenneinrichtung, die dazu eingerichtet ist, die Bauteile von dem ersten Träger berührend oder berührungslos abzutrennen, um sie auf den zweiten Träger zu übertragen;
- eine erste Fördereinrichtung, die dazu vorgesehen und eingerichtet ist, die erste Aufnahme quer zur Förderrichtung des zweiten Trägers relativ zu der zweiten Aufnahme zu bewegen;
- eine zweite Fördereinrichtung, die dazu vorgesehen und eingerichtet ist, die Trenneinrichtung quer zur Förderrichtung des zweiten Trägers relativ zu der zweiten Aufnahme zu bewegen;
- eine erste Inspektionseinrichtung , die dazu vorgesehen und eingerichtet ist, wenigstens eines der Bauteile in seiner Lage relativ zu einer Ablageposition auf der den zweiten Träger führenden zweiten Aufnahme zu erfassen;
- eine zweite Inspektionseinrichtung, die aufstromseitig zur Ablageposition angeordnet und dazu vorgesehen und eingerichtet ist, wenigstens eine der Vielzahl elektronischer Teilbaugruppen auf dem zweiten Träger in ihrer Lage relativ zu der zweiten Aufnahme zu erfassen und eine die erfasste Lage repräsentierende Information an eine Steuerung zu signalisieren;
- eine dritte Fördereinrichtung, die dazu vorgesehen und eingerichtet ist, in Ansprache auf von der Steuerung signalisierte Information, den zweiten Träger in seiner Lage relativ zu der Ablageposition so zu fördern, dass die wenigstens eine der Vielzahl elektronischer Teilbaugruppen auf dem zweiten Träger zu der Ablageposition auf der den zweiten Träger führenden zweiten Aufnahme gelangt.

### Vorteile, Ausgestaltungen und Funktionsweise

Bisher wird für die Bestückung von Teilbaugruppen oder Anschlussrahmen mittels Direktablage (DDA = direkt die assembly) in der Regel einreihiges Bandmaterial als zweiten Träger verwendet, auf dem die Bauteile aus dem ersten Träger abgelegt werden. Die vorgestellte Lösung erlaubt, mehrreihiges Bandmaterial als zweiten Träger zu verwenden. Dadurch werden die verringerte Komplexität und der höhere Durchsatz der Direktablage-Anordnung auf den Bereich von Anlagen übertragen, die in der Lage sind, mehrreihiges Bahnmaterial verarbeiten. Mehrreihiges Bahnmaterial wird herkömmlicherweise in sog. pick-and-place Anlagen oder sog. flip-chip Anlagen mit Bauteilen bestückt. Die hier vorgeschlagene Lösung erlaubt auch, die bisherige Inspektion des zweiten Trägers an der Ablage-Position zu ersetzen. Somit können auch wenig bis gar nicht transparente zweite Träger ohne Genauigkeitseinbußen bei der Bauteil-Ablage verwendet werden.

Herkömmliche Anlagen, die mehrreihiges Bahnmaterial zu verarbeiten eingerichtet sind, arbeiten in der Regel mit Bondköpfen, die die Bauteil in einem Bereich außerhalb des Bahnmaterials aufnehmen, in X/Y-Richtung zu den Ablagepositionen auf dem Bahnmaterial positionieren und dann in Z-Richtung auf das Bahnmaterial aufsetzen.

Herkömmliche DDA Anlagen für einreihiges Bahnmaterial nutzen zur Erkennung der Ablageposition auf dem Bahnmaterial vor Chipablage eine Kamera, die direkt im Ablagebereich auf der Rück-/)Unterseite des Bahnmaterials des zweiten Trägers angebracht ist. Durch diese Anordnung können herkömmliche DDA Anlagen nur volltransparente Materialien, z. B. PET, ohne Einschränkung der Ablage-Genauigkeit verarbeiten, intransparente Materialien als zweiter Träger sind generell nicht möglich.

Die vorgeschlagene Lösung erfasst die Ablageposition auf dem Bahnmaterial (räumlich / zeitlich) vor der eigentlichen Bauteil-Ablage, wobei die zweite Inspektionseinrichtung direkt, also nicht durch den zweiten Träger hindurch, sondern die jeweilige Bauteil-Ablagestelle auf dem zweiten Träger selbst erfasst. Dann wird der zweite Träger so kontrolliert zu der Ablageposition gefördert, dass die Bauteil-Ablagestelle möglichst präzise mit der Position des abzulegenden Bauteils an dem ersten Träger fluchtet, wenn die Trenneinrichtung dieses Bauteil von dem ersten Träger trennt und dieses dann in Z-Richtung auf den zweiten Träger übertragen wird.

Im Vergleich zu pick-and-place Anlagen oder zu flip-chip Anlagen ist mit der vorgeschlagenen Lösung wegen ihrer strukturell niedrigeren Komplexität ein signifikant höherer Durchsatz der Bauteile erzielbar. Dabei können die Bauteile direkt einzeln aus dem (zersägten) Wafer getrennt werden und in jeweilige Teilbaugruppe (oder Anschlussrahmen oder dergl.) auf dem zweiten Träger platziert werden; ein Zwischenträger wie bei herkömmlichen Bestückautomaten ist nicht mehr erforderlich. Die Transparenz des Materials des zweiten Trägers hat keinen Einfluss mehr auf die Lage-Genauigkeit beim Ablegen des Bauteils.

### Ausgestaltungen der vorgeschlagenen Lösung

In einer Variante befindet sich die erste Aufnahme mit dem ersten Träger unmittelbar über dem zweiten Träger auf der zweiten Aufnahme. Im Gegensatz zu bisherigen Lösungen haben die erste Aufnahme und die Trenneinrichtung einen der Breite des zweiten Trägers zumindest annähernd entsprechenden Bewegungsraum quer zur Förderrichtung des zweiten Trägers. Dadurch vergrößert sich der Arbeits- /Bauteil-Ablagebereich signifikant über die Breite des zweiten Trägers. Mithin können mehrere nebeneinander liegende Reihen elektronischer Teilbaugruppen, zum Beispiel RFID-Antennen, auf einem breiten zweiten Träger mit dem ersten Träger erreicht und durch Betätigen der Trenneinrichtung an der Ablageposition bestückt werden.

In einer Variante hat der erste Träger eine der Trenneinrichtung zugewandte erste Seite und eine von der Trenneinrichtung abgewandte zweite Seite, die dem zweiten Träger auf/an der zweiten Aufnahme zugewandt ist, wobei auf der zweiten Seite des ersten Trägers die Vielzahl der Bauteile lösbar aufgebracht ist; ist die erste Inspektionseinrichtung dazu eingerichtet, Bilddaten einer Region zu erfassen, in der die Trenneinrichtung zum berührenden oder berührungslosen Interagieren mit wenigstens einem der Bauteile eingerichtet ist um dieses von dem ersten Träger zu trennen; und ist die Steuerung dazu eingerichtet, aus den erfassten Bilddaten Positionsdaten des zu übertragenden Bauteils zu ermitteln, sowie aufgrund der Positionsdaten Steuerbefehle für die Trenneinrichtung und die jeweiligen Fördereinrichtungen zu erzeugen.

In einer Variante ist die zweite Inspektionseinrichtung - bezogen auf die Förderrichtung des zweiten Trägers - aufstromseitig zur Ablageposition bei dem zweiten Träger angeordnet und dazu vorgesehen und eingerichtet, quer zur Förderrichtung des zweiten Trägers jeweils ein oder mehrere der Vielzahl elektronischer Teilbaugruppen auf dem zweiten Träger in ihrer Lage relativ zu der zweiten Aufnahme zu erfassen und eine die erfasste Lage repräsentierende Information an die Steuerung zu signalisieren.

In einer Variante ist der dritten Fördereinrichtung eine erste Sensoreinrichtung zugeordnet, die dazu vorgesehen und eingerichtet ist, der Steuerung Information zu Förderrichtung und Förderweg des zweiten Trägers relativ zu der Ablageposition zu signalisieren.

In einer Variante ist die Steuerung dazu vorgesehen und eingerichtet, basierend auf der Information der zweiten Inspektionseinrichtung zur Lage der wenigstens einen elektronische Teilbaugruppe und der Information zu Förderrichtung und Förderweg des zweiten Trägers sowie basierend auf der Information der ersten Inspektionseinrichtung zur Lage wenigstens eines der Bauteile relativ zur Ablageposition die zweite Fördereinrichtung anzusteuern, um die Trenneinrichtung quer zur Förderrichtung des zweiten Trägers zu der Ablageposition zu bewegen, und die Trenneinrichtung im Sinne eines Trennens des Bauteils von dem ersten Träger zu aktivieren.

In einer Variante umfasst die Vorrichtung eine vierte Fördereinrichtung, die dazu vorgesehen und eingerichtet ist, in Ansprache auf von der Steuerung signalisierte Information, die erste Aufnahme längs der Förderrichtung des zweiten Trägers relativ zu der zweiten Aufnahme zu bewegen; und/oder eine fünfte Fördereinrichtung, die dazu vorgesehen und eingerichtet ist, in Ansprache auf von der Steuerung signalisierte Information, die erste Aufnahme um einen Winkel (Theta) relativ zu der zweiten Aufnahme zu drehen.

In einer weiteren Variante umfasst die Vorrichtung eine sechste Fördereinrichtung, die dazu vorgesehen und eingerichtet ist, in Ansprache auf von der Steuerung signalisierte Information, den zweiten Träger so (schlupffrei und so dehnungsfrei) entlang der Förderrichtung über die zweite Aufnahme zu fördern, dass die wenigstens eine der Vielzahl elektronischer Teilbaugruppen auf dem zweiten Träger zu der Ablageposition auf der den zweiten Träger führenden zweiten Aufnahme gelangt.

In einer weiteren Variante der Vorrichtung umfasst die Trenneinrichtung, sofern sie dazu eingerichtet ist, die Bauteile von dem ersten Träger berührend abzutrennen, eine Stoßnadel, die dazu eingerichtet und dimensioniert ist, in Ansprache auf von der Steuerung signalisierte Information den ersten Träger zu punktieren, um jeweils eines der Bauteile von dem ersten Träger abzulösen und auf den zweiten Träger zu übertragen; oder sofern sie dazu eingerichtet ist, die Bauteile von dem ersten Träger berührungslos abzutrennen, umfasst die Trenneinrichtung eine steuerbare Energiequelle, die dazu eingerichtet und dimensioniert ist, in Ansprache auf von der Steuerung signalisierte Information den ersten Träger mit Energie zu beschicken, um jeweils eines der Bauteile von dem ersten Träger abzulösen und auf den zweiten Träger zu übertragen.

In einer weiteren Variante der Vorrichtung umfasst die zweite Aufnahme eine (kreis-)zylindrische Trommel oder eine konvex gekrümmte Fläche, über die der zweite Träger zu der Ablageposition auf der zweiten Aufnahme gelangt, wobei in einer Variante die zweite Aufnahme an ihrer den zweiten Träger führenden Mantel-/Oberfläche Auslässe aufweist, die dazu eingerichtet sind, den zweiten Träger mittels Unterdruck an der zweiten Aufnahme (schlupffrei und dehnungsfrei) zu halten.

In einer weiteren Variante umfasst die Vorrichtung eine dritte Inspektionseinrichtung, die - bezogen auf die Förderrichtung des zweiten Trägers - abstromseitig zur Ablageposition angeordnet und dazu vorgesehen und eingerichtet ist, wenigstens eine der Vielzahl elektronischer Teilbaugruppen auf dem zweiten Träger und das auf sie übertragene Bauteil in ihrer Lage relativ zu einander zu erfassen und eine die erfasste Lage repräsentierende Information an die Steuerung zu signalisieren.

In einer weiteren Variante umfasst die Vorrichtung eine achte Fördereinrichtung, die dazu vorgesehen und eingerichtet ist, die zweite Inspektionseinrichtung relativ zu der zweiten Aufnahme und der Ablageposition zu fördern, um wenigstens eine Bauteil-Ablagestelle auf dem zweiten Träger durch die zweite Inspektionseinrichtung zu erfassen und/oder, um wenigstens eine der Vielzahl elektronischer Teilbaugruppen auf dem zweiten Träger in ihrer Lage zu erfassen und eine die erfasste Lage repräsentierende Information an die Steuerung zu signalisieren; und /oder eine neunte Fördereinrichtung, die dazu vorgesehen und eingerichtet ist, die dritte Inspektionseinrichtung relativ zu der zweiten Aufnahme und der Ablageposition zu fördern, um wenigstens eine der Vielzahl elektronischer Teilbaugruppen auf dem zweiten Träger und das auf sie übertragene Bauteil in ihrer Lage relativ zu einander zu erfassen und eine die erfasste Lage repräsentierende Information an die Steuerung zu signalisieren.

Alternativ sind die zweite und/oder die dritte Inspektionseinrichtung schwenkbar an der zweiten Aufnahme gelagert und in ihrer Ausrichtung auf die Bauteil-Ablagestelle bzw. die elektronischen Teilbaugruppen auf dem zweiten Träger und das auf sie übertragene Bauteil elektronisch gesteuert oder manuell verstellbar.

Zur Lösung dieser Aufgabe wird außerdem eine weitere Vorrichtung zum Auftragen von Klebstoff aus einem Vorrat auf einen zweiten Träger vorgeschlagen, wobei der zweite Träger quasi-endlos ausgestaltet ist und in seiner Längs- und Quererstreckung eine Vielzahl elektronischer Teilbaugruppen trägt, zu denen der Klebstoff aufzutragen ist um danach ein Bauteil zu einer der Teilbaugruppen zu übertragen, und wobei die weitere Vorrichtung umfasst: eine dritte Aufnahme, die dazu eingerichtet ist, dass über sie der zweite Träger entlang seiner Längserstreckung in einer Förderrichtung des zweiten Trägers zu führen ist; eine Spendeeinrichtung für Klebstoff, die dazu eingerichtet ist, gesteuert und dosiert Klebstoff zu der dritten Aufnahme hin auf eine Klebe-Stelle am zweiten Träger an einer Klebstoff-Ausbring-position auszubringen, an der sich eine der Vielzahl elektronischer Teilbaugruppen befindet; eine elfte Fördereinrichtung, die dazu vorgesehen und eingerichtet ist, die Spendeeinrichtung für Klebstoff quer zur Förderrichtung des zweiten Trägers relativ zu der dritten Aufnahme zu bewegen; eine vierte Inspektionseinrichtung, die aufstromseitig zur Klebstoff-Ausbringposition angeordnet und dazu vorgesehen und eingerichtet ist, wenigstens eine der Vielzahl elektronischer Teilbaugruppen auf dem zweiten Träger in ihrer Lage relativ zu der dritten Aufnahme zu erfassen und eine die erfasste Lage repräsentierende Information an die Steuerung zu signalisieren; eine zwölfte Fördereinrichtung, die dazu vorgesehen und eingerichtet ist, in Ansprache auf von der Steuerung signalisierte Information, den zweiten Träger in seiner Lage relativ zur Klebstoff-Ausbringposition so zu fördern, dass die wenigstens eine der Vielzahl elektronischer Teilbaugruppen mit der Klebe-Stelle auf dem zweiten Träger zu der Klebstoff-Ausbringposition auf der den zweiten Träger führenden dritten Aufnahme gelangt.

Die Vorrichtung zum Klebstoff-Ausbringen ist vorteilhaft im Zusammenwirken mit und aufstromseitig zu der Vorrichtung zum Übertragen elektronischer Bauteile von einem ersten Träger zu einem zweiten Träger, aber auch unabhängig davon einzusetzen.

Auch bei der Vorrichtung zum Klebstoff-Ausbringen gilt, dass sie erlaubt, mehrreihiges Bandmaterial als zweiten Träger zu verwenden, wobei die verringerte Komplexität und der höhere Durchsatz beim Klebstoff-Ausbringen auf den Bereich von Anlagen übertragen, die in der Lage sind, mehrreihiges Bahnmaterial verarbeiten. Die hier vorgeschlagene Lösung zum Klebstoff-Ausbringen erlaubt auch, die bisherige Inspektion des zweiten Trägers an der Klebstoff-Ausbring-Position zu ersetzen. Somit können auch wenig bis gar nicht transparente zweite Träger ohne Genauigkeitseinbußen beim Klebstoff-Ausbringen vor der Bauteil-Ablage verwendet werden.

Herkömmliche DDA Anlagen für einreihiges Bahnmaterial nutzen zur Erkennung der Klebstoff-Ausbring-Position auf dem Bahnmaterial vor dem Klebstoff-Ausbringen eine Kamera, die direkt im Ablagebereich auf der Rück-/)Unterseite des Bahnmaterials des zweiten Trägers angebracht ist. Durch diese Anordnung können herkömmliche DDA Anlagen nur volltransparente Materialien, z. B. PET, ohne Einschränkung der Ablage-Genauigkeit verarbeiten, intransparente Materialien als zweiter Träger sind generell nicht möglich.

Die vorgeschlagene Lösung erfasst die Klebe-Stelle auf dem Bahnmaterial (räumlich / zeitlich) vor dem eigentlichen Klebstoff-Ausbringen, wobei die vierte Inspektionseinrichtung direkt, also nicht durch den zweiten Träger hindurch, sondern die jeweilige Klebe-Stelle - im Zusammenhang mit der jeweiligen elektronischen Teilbaugruppe - auf dem zweiten Träger selbst erfasst. Dann wird der zweite Träger so kontrolliert zu der Klebstoff-Ausbring-Position gefördert, dass die Klebe-Stelle möglichst präzise mit der Position des Auslasses der Spendeeinrichtung für Klebstoff fluchtet, wenn die Spendeeinrichtung (dosiert eine Portion) Klebstoff auf die Klebe-Stelle ausbringt.

In einer Variante ist die vierte Inspektionseinrichtung, die - bezogen auf die Förderrichtung des zweiten Trägers - aufstromseitig zur Klebstoff-Ausbring-Position bei dem zweiten Träger angeordnet und dazu vorgesehen und eingerichtet, quer zur Förderrichtung des zweiten Trägers jeweils ein oder mehrere der Vielzahl elektronischer Teilbaugruppen auf dem zweiten Träger in ihrer Lage relativ zu der dritten Aufnahme zu erfassen und eine die erfasste Lage repräsentierende Information an die Steuerung zu signalisieren.

In einer Variante ist der zwölften Fördereinrichtung eine zweite Sensoreinrichtung zugeordnet, die dazu vorgesehen und eingerichtet ist, der Steuerung Information zu Förderrichtung und Förderweg des zweiten Trägers relativ zur Klebstoff-Ausbring-Position zu signalisieren.

In einer Variante ist die Steuerung dazu vorgesehen und eingerichtet, basierend auf der Information der vierten Inspektionseinrichtung zur Lage der wenigstens einen elektronische Teilbaugruppe und der Information zu Förderrichtung und Förderweg des zweiten Trägers sowie basierend auf der Information der vierten Inspektionseinrichtung zur Lage wenigstens eines der Bauteile relativ zur Klebstoff-Ausbring-Position die elfte Fördereinrichtung anzusteuern, um die Spendeeinrichtung quer zur Förderrichtung des zweiten Trägers zu der Ablageposition zu bewegen, und die Spendeeinrichtung im Sinne eines Trennens des Bauteils von dem ersten Träger zu aktivieren.

In einer Variante umfasst die Vorrichtung eine dreizehnte Fördereinrichtung, die dazu vorgesehen und eingerichtet ist, in Ansprache auf von der Steuerung signalisierte Information, den zweiten Träger so (schlupffrei und so dehnungsfrei) entlang der Förderrichtung über die zweite Aufnahme zu fördern, dass die wenigstens eine der Vielzahl elektronischer Teilbaugruppen auf dem zweiten Träger zu der Klebstoff-Ausbring-Position auf der den zweiten Träger führenden zweiten Aufnahme gelangt.

In einer weiteren Variante der Vorrichtung umfasst die dritte Aufnahme eine (kreis-)zylindrische Trommel oder eine konvex gekrümmte Fläche, über die der zweite Träger zu der Ablageposition auf der dritten Aufnahme gelangt, wobei in einer Variante die zweite Aufnahme an ihrer den zweiten Träger führenden Mantel-/Oberfläche Auslässe aufweist, die dazu eingerichtet sind, den zweiten Träger mittels Unterdruck an der dritten Aufnahme (schlupffrei und dehnungsfrei) zu halten.

In einer weiteren Variante umfasst die Vorrichtung eine fünfte Inspektionseinrichtung, die - bezogen auf die Förderrichtung des zweiten Trägers - abstromseitig zur Klebstoff-Ausbring-Position angeordnet und dazu vorgesehen und eingerichtet ist, wenigstens eine der Vielzahl elektronischer Teilbaugruppen auf dem zweiten Träger und den auf sie ausgebrachten Klebstoff in ihrer Lage relativ zu einander zu erfassen und eine die erfasste Lage repräsentierende Information an die Steuerung zu signalisieren.

In einer weiteren Variante umfasst die Vorrichtung eine vierzehnte Fördereinrichtung, die dazu vorgesehen und eingerichtet ist, die vierte Inspektionseinrichtung relativ zu der dritten Aufqnahme und der Klebstoff-Ausbring-Position zu fördern, um wenigstens eine Klebestelle auf dem zweiten Träger durch die die fünfte Inspektionseinrichtung zu erfassen, um wenigstens eine der Vielzahl elektronischer Teilbaugruppen auf dem zweiten Träger in ihrer Lage zu erfassen und eine die erfasste Lage repräsentierende Information an die Steuerung zu signalisieren; und /oder eine fünfzehnte Fördereinrichtung, die dazu vorgesehen und eingerichtet ist, die fünfte Inspektionseinrichtung relativ zu der dritten Aufnahme und der Klebstoff-Ausbring-Position zu fördern, um wenigstens eine der Vielzahl elektronischer Teilbaugruppen auf dem zweiten Träger und den auf sie ausgebrachten Klebstoff in ihrer Lage relativ zu einander zu erfassen und eine die erfasste Lage repräsentierende Information an die Steuerung zu signalisieren.

Alternativ sind die vierte und/oder die fünfte Inspektionseinrichtung schwenkbar gelagert und in ihrer Ausrichtung elektronisch gesteuert oder manuell verstellbar.

In den vorstehend beschriebenen Vorrichtungen zum Übertragen elektronischer Bauteile von einem ersten Träger zu einem zweiten Träger und/oder zum Auftragen von Klebstoff aus einem Vorrat auf einen zweiten Träger können die zweiten bis fünften Inspektionseinrichtungen wie folgt ausgestaltet sein. Einer Bilderfassungseinrichtung ist eine Beleuchtungseinrichtung zugeordnet, wobei die Beleuchtungseinrichtung dazu eingerichtet ist, Licht unterschiedlicher Wellenlänge auf eine zweite Aufnahme zu richten, die dazu eingerichtet ist, ein auf dem zweiten Träger befindliches Objekt zu tragen, das von der Bilderfassungseinrichtung aufzunehmen ist, eine sechzehnte, siebzehnte, achtzehnte und/oder neunzehnte Fördereinrichtung ist dazu eingerichtet, die jeweilige Bilderfassungseinrichtung mit der ihr zugeordneten Beleuchtungseinrichtung entlang der zweiten Aufnahme zu fördern, und eine achte, neunte, vierzehnte, und/oder fünfzehnte Fördereinrichtung, die dazu vorgesehen und eingerichtet ist, die jeweilige zweite, dritte, vierte und/oder fünfte Inspektionseinrichtung relativ zu der jeweilige zweiten und/oder dritten Aufnahme und der Bauteil-Ablageposition oder der Klebstoff-Ausbring-Position entlang der Förderrichtung des zweiten Träger zu fördern.

In einer Variante der Inspektionseinrichtung umfasst die Beleuchtungseinrichtung eine Weiß-Licht-, eine (Infra-)Rot-Licht-, und/oder eine (Ultra-)Blau-Licht-Quelle.

In einer Variante der Beleuchtungseinrichtung sind die (Infra-)Rot-Licht-, und/oder die (Ultra-)Blau-Licht-Quelle als Ringlichtquelle ausgestaltet, die einen Erfassungsbereich der Bilderfassungseinrichtung zumindest teilweise umgibt.

In einer Variante der Inspektionseinrichtung ist die Weiß-Licht-Quelle auf einer von dem Erfassungsbereich der Bilderfassungseinrichtung abliegenden Seite einer zumindest teilweise licht-durchlässigen Strahlumlenkung angeordnet.

In einer Variante der Inspektionseinrichtung umfasst die Bilderfassungseinrichtung eine Fokussieroptik, die einen fest einstellbaren Abstand zur ihr zugewandten Seite einer zumindest teilweise Licht-durchlässigen Strahlumlenkung angeordnet ist.

Auch wenn einige der voranstehend beschriebenen Aspekte in Bezug auf die Betriebsweise der Vorrichtung beschrieben wurden, so können diese Aspekte auch die Struktur der Vorrichtung betreffen. Genauso können die voranstehend in Bezug auf die Vorrichtung beschriebenen Aspekte in entsprechender Weise auf die Betriebsweise zutreffen. Die einzelnen Aspekte der Vorrichtung und der Betriebsweise sind zwar im Zusammenhang beschrieben um ihre Interaktion zu erläutern; sie sind jedoch auch unabhängig voneinander, den anderen Vorrichtungen und anderen Betriebsweisen offenbart.

### Kurzbeschreibung der Zeichnungen

Weitere Ziele, Merkmale, Vorteile und Anwendungsmöglichkeiten ergeben sich aus der nachfolgenden Beschreibung von nicht einschränkend zu verstehenden Ausführungsbeispielen mit Bezug auf die zugehörigen Zeichnungen. Dabei zeigen alle beschriebenen und/oder bildlich dargestellten Merkmale für sich oder in beliebiger Kombination den hier offenbarten Gegenstand, auch unabhängig von ihrer Gruppierung in den Ansprüchen oder deren Rückbeziehungen. Die Abmessungen und Proportionen der in den Figuren gezeigten Komponenten sind hierbei nicht unbedingt maßstäblich; sie können bei zu implementierenden Ausführungsformen vom hier Veranschaulichten abweichen.
- Figur 1: zeigt eine schematische seitliche Draufsicht der Vorrichtung zum Übertragen elektronischer Bauteile von einem ersten Träger zu einem zweiten Träger und einer Vorrichtung zum Aufbringen von Klebstoff auf den zweiten Träger.
- Fig. 2: zeigt eine schematische Draufsicht auf einen in X-/Y-/Theta-Koordinaten verstellbaren Tisch.
- Fig. 3: zeigt eine schematische Draufsicht auf die zweite bis fünfte Inspektionseinrichtung.

Die hier beschriebenen Verfahrens- und Vorrichtungsvarianten sowie deren Funktions- und Betriebsaspekte dienen lediglich dem besseren Verständnis ihrer Struktur, Funktionsweise und Eigenschaften; sie schränken die Offenbarung nicht etwa auf die Ausführungsbeispiele ein. Die Figuren sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Figuren oder im Text offenbart ist/sind, mit allen Ansprüchen, jedem Merkmal im Text und in den anderen Figuren, anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen den beschriebenen Vorrichtungen zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Figuren umfasst und können zum Gegenstand weiterer Ansprüche gemacht werden. Auch die Ansprüche limitieren nicht die Offenbarung und damit die Kombinationsmöglichkeiten aller aufgezeigten Merkmale untereinander. Alle offenbarten Merkmale sind explizit auch einzeln und in Kombination mit allen anderen Merkmalen hier offenbart.

### Detaillierte Beschreibung

In den Figuren sind einander entsprechende oder funktionsähnliche Bauteile mit übereinstimmenden Bezugszeichen versehen. Das Verfahren und die Vorrichtung werden nun anhand von Ausführungsbeispielen beschrieben.

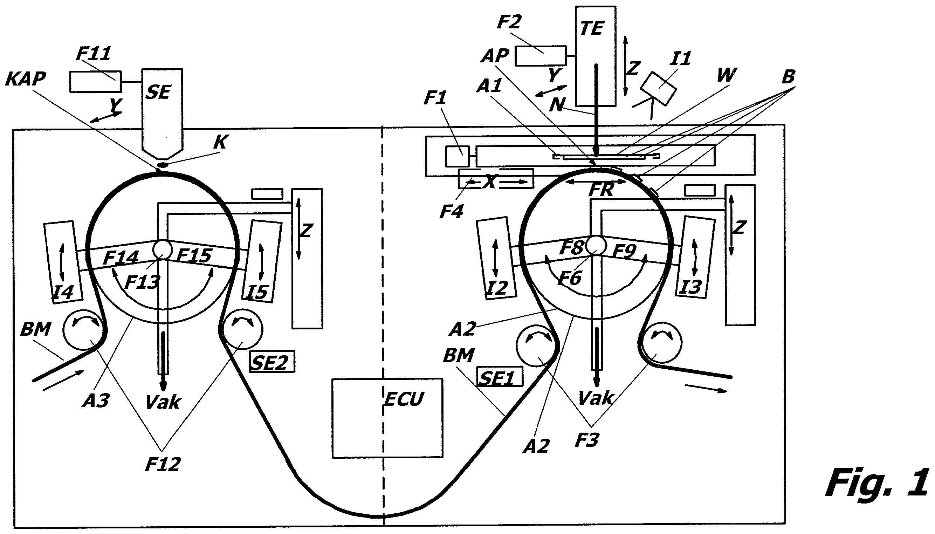

Die Fig. 1 zeigt (auf der rechten Seite) eine Vorrichtung 100 zum Übertragen elektronischer Bauteile B von einem ersten Träger W zu einem zweiten Träger BM. Der erste Träger W hat in dieser Variante die Gestalt eines hier etwa kreisrunden Halbleiter-Bauteil-Wafers und trägt eine Vielzahl vereinzelter Bauteile B, die von ihm in weiter unten beschriebener Weise lösbar sind. Der zweite Träger BM ist als quasi-endlose Bandmaterial ausgestaltet und trägt in seiner Längs- und Quererstreckung eine Vielzahl elektronischer Teilbaugruppen ANT. In der hier gezeigten Variante sind die Teilbaugruppen ANT gedruckte Antennenabschnitte eines RFID-Moduls. Auf jedes der Vielzahl elektronischer Teilbaugruppen ANT ist jeweils eines der Bauteile B von dem ersten Träger W zu übertragen. Die Vorrichtung hat eine erste Aufnahme A1, die dazu eingerichtet ist, den ersten Träger W aufzunehmen. Die erste Aufnahme A1 ist in ihrer Gestalt an den ersten Träger W angepasst.

Eine zweite Aufnahme A2 hat in der gezeigten Variante die Gestalt einer kreiszylindrischen Trommel. Über die zylindermantel-förmige Außenwand wird der zweite Träger BM entlang seiner Längserstreckung in einer Förderrichtung FR geführt. Details hierzu sind weiter unten erläutert. Die erste Aufnahme A1 nimmt den ersten Träger W so auf, dass die von ihm getragenen Bauteile B zu der zweiten Aufnahme A2 hin orientiert sind. Auf der von der zweiten Aufnahme A2 abliegenden Seite der ersten Aufnahme A1 ist eine Trenneinrichtung TE vorgesehen. Der erste Träger W hat eine der Trenneinrichtung TE zugewandte erste Seite und eine von der Trenneinrichtung abgewandte zweite Seite, die dem zweiten Träger BM auf/an der zweiten Aufnahme A2 zugewandt ist. Auf der zweiten Seite des ersten Trägers W ist die Vielzahl der Bauteile B lösbar aufgebracht. Die Trenneinrichtung TE dient dazu, die Bauteile B von dem ersten Träger W berührend oder berührungslos abzutrennen, um sie an einer Ablageposition AP auf den zweiten Träger BM zu übertragen.

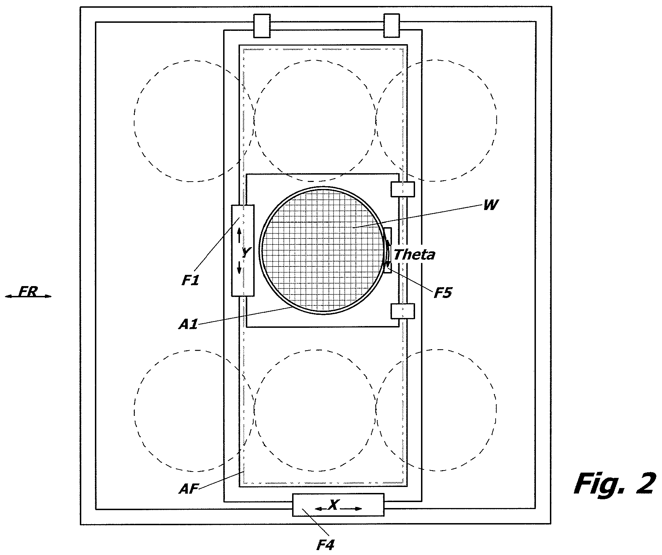

Die erste Aufnahme A1 ist Teil eines in X-/Y-/Theta-Koordinaten verstellbaren Tisches, dessen einzelne X-/Y-Achsen und Drehstellung Theta jeweils mit einer von einer elektronischen Steuerung ECU angesteuerten Fördereinrichtung zu verstellen sind. Insbesondere ist eine erste Fördereinrichtung F1 in Gestalt eines Linear-Servoantriebs dazu vorgesehen und eingerichtet, die erste Aufnahme A1 quer zur Förderrichtung FR des zweiten Trägers BM relativ zu der zweiten Aufnahme A2 zu bewegen. (Siehe auch Fig. 2). Eine zweite Fördereinrichtung F2 in Gestalt eines Linear-Servoantriebs ist dazu vorgesehen und eingerichtet, die Trenneinrichtung TE quer zur Förderrichtung FR des zweiten Trägers BM relativ zu der zweiten Aufnahme A2 zu bewegen.

Eine erste Inspektionseinrichtung I1 in Gestalt einer Kamera ist der Trenneinrichtung TE zugeordnet und dient dazu, wenigstens eines der Bauteile B in seiner Lage relativ zu einer Ablageposition AP auf der den zweiten Träger BM führenden zweiten Aufnahme A2 zu erfassen.

Eine zweite Inspektionseinrichtung I2 ist aufstromseitig zur Ablageposition AP angeordnet und der zweiten Aufnahme A2 zugeordnet. Diese zweite Inspektionseinrichtung I2 ist sowohl in Längserstreckung der trommelförmigen zweiten Aufnahme A2, also quer zur Förderrichtung FR des zweiten Trägers BM gesteuert verfahrbar, als auch um einen vorgestimmten Winkelbetrag entlang des Umfangs an der Mantelfläche der trommelförmigen zweiten Aufnahme A2 manuell oder motorisch verstellbar. Beispielsweise kann die Inspektionseinrichtung I2 über einen Schwenkarm mit der zweiten Aufnahme A2 verbunden sein.

Die zweite Inspektionseinrichtung I2 dient dazu, wenigstens eine der Vielzahl elektronischer Teilbaugruppen ANT auf dem zweiten Träger BM in ihrer Lage relativ zu der zweiten Aufnahme A2 zu erfassen und eine die erfasste Lage repräsentierende Information an eine Steuerung ECU zu signalisieren. Eine dritte Fördereinrichtung F3 ist in dieser Ausgestaltung durch zwei gesteuert anzutreibende Transportwalzen gebildet, die auf- und abstromseitig zu der trommelförmigen zweiten Aufnahme A2 angeordnet sind, und um die der zweite Träger BM geführt ist. In Ansprache auf von der Steuerung ECU signalisierte Information, wird der zweite Träger BM durch die zwei gesteuert anzutreibenden Transportwalzen in seiner Lage relativ zu der Ablageposition AP so gefördert, dass die wenigstens eine der Vielzahl elektronischer Teilbaugruppen ANT auf dem zweiten Träger BM zu der Ablageposition AP auf der den zweiten Träger BM führenden zweiten Aufnahme A2 gelangt.

Dabei sei verstanden, dass sich die Ablageposition AP sowohl in Längsrichtung des zweiten Trägers BM als auch in dessen Quererstreckung verändert, je nachdem, welche Teilbaugruppe ANT auf dem zweiten Träger BM mit einem Bauteil B zu bestücken ist, während sich ein entsprechender Bereich des zweiten Trägers BM auf der zweiten Aufnahme A2 befindet und mit dem ersten Träger W zur Deckung zu bringen ist. Dementsprechend ist auch der erste Träger W durch die Steuerung ECU gesteuert, sowohl in Längsrichtung des zweiten Trägers BM als auch in dessen Quererstreckung, zu verlagern.

Ersichtlich ist ein mehrreihiges Bandmaterial als zweiter Träger verwendbar. Hierunter sei Bandmaterial verstanden, das in seiner Quererstreckung mehrere Reihen an Teilbaugruppen ANT trägt. Als zweiter Träger BM kann wenig bis gar nicht transparentes Trägermaterial ohne Genauigkeitseinbußen bei der Bauteil-Ablage verwendet werden.

Die Ablageposition AP auf dem Bahnmaterial des zweiten Träger BM wird räumlich / zeitlich vor der eigentlichen Bauteil-Ablage erfasst. Dabei erfasst die zweite Inspektionseinrichtung I2 direkt, also nicht durch den zweiten Träger hindurch, sondern die jeweilige Bauteil-Ablagestelle auf dem zweiten Träger BM selbst. Dann wird der zweite Träger BM so kontrolliert zu der Ablageposition AP gefördert, dass die Bauteil-Ablagestelle möglichst präzise mit der Position des abzulegenden Bauteils an dem ersten Träger W fluchtet, wenn die Trenneinrichtung TE dieses Bauteil B von dem ersten Träger W trennt und dieses dann in Z-Richtung auf den zweiten Träger BM übertragen wird.

Die erste Aufnahme A1 mit dem ersten Träger W befindet sich unmittelbar über dem zweiten Träger BM an der zweiten Aufnahme A2. Dabei haben die erste Aufnahme A1 und die Trenneinrichtung TE einen der Breite des zweiten Trägers BM zumindest annähernd entsprechenden Bewegungsraum quer zur Förderrichtung FR des zweiten Trägers BM. (Siehe Fig. 2) Dadurch erstreckt sich der Arbeits- /Bauteil-Ablagebereich in etwa über die Breite des zweiten Trägers BM. In einer Variante können der Bewegungsraum der Aufnahme A1 und/oder der Trenneinrichtung TE quer zur Förderrichtung FR des zweiten Trägers BM größer sein als die Quererstreckung des zweiten Trägers BM, sodass zumindest der erste Träger W annähernd vollständig oder zumindest das Zentrum/Mittelachse des ersten Trägers W über die Quererstreckung des zweiten Trägers BM hinaus positioniert werden kann. Mithin können mehrere nebeneinander liegende Reihen elektronischer Teilbaugruppen ANT, zum Beispiel RFID-Antennen, auf einem breiten zweiten Träger BM mit dem ersten Träger W erreicht und durch Betätigen der Trenneinrichtung TE an der Ablageposition AP bestückt werden.

Die erste Inspektionseinrichtung I1 ist dazu eingerichtet, Bilddaten einer Region zu erfassen, in der die Trenneinrichtung TE zum berührenden oder berührungslosen Interagieren mit wenigstens einem der Bauteile B eingerichtet ist um dieses von dem ersten Träger W zu trennen.

Die Steuerung ECU ist dazu eingerichtet, aus den erfassten Bilddaten Positionsdaten des zu übertragenden Bauteils B zu ermitteln, sowie aufgrund der Positionsdaten Steuerbefehle für die Trenneinrichtung TE und die jeweiligen Fördereinrichtungen F1, ... Fn zu erzeugen.

Die zweite Inspektionseinrichtung I2 ist bezogen auf die Förderrichtung X des zweiten Trägers BM aufstromseitig zur Ablageposition AP bei dem zweiten Träger A2 angeordnet und dazu vorgesehen und eingerichtet, quer zur Förderrichtung X des zweiten Trägers BM jeweils ein oder mehrere der Vielzahl elektronischer Teilbaugruppen ANT auf dem zweiten Träger BM in ihrer Lage relativ zu der zweiten Aufnahme zu erfassen und eine die erfasste Lage repräsentierende Information an die Steuerung ECU zu signalisieren.

Der dritten Fördereinrichtung F3 ist eine erste Sensoreinrichtung SE1 zugeordnet, die dazu vorgesehen und eingerichtet ist, der Steuerung ECU Information zu Förderrichtung und Förderweg des zweiten Trägers BM relativ zu der Ablageposition AP zu signalisieren.

Die Steuerung ECU dient dazu, basierend auf der Information der zweiten Inspektionseinrichtung I2 zur Lage der wenigstens einen elektronische Teilbaugruppe ANT und der Information zu Förderrichtung und Förderweg des zweiten Trägers BM sowie basierend auf der Information der ersten Inspektionseinrichtung I1 zur Lage wenigstens eines der Bauteile B relativ zur Ablageposition AP die zweite Fördereinrichtung F2 anzusteuern. So bewirkt die Steuerung ECU, dass die Trenneinrichtung TE (in Förderrichtung und) quer zur Förderrichtung X des zweiten BM Trägers zu der Ablageposition AP bewegt wird, und die Trenneinrichtung TE im Sinne eines Trennens des Bauteils B von dem ersten Träger W aktiviert wird.

Eine vierte Fördereinrichtung F4 dient dazu, in Ansprache auf von der Steuerung ECU signalisierte Information, die erste Aufnahme A1 längs der Förderrichtung FR des zweiten Trägers BM relativ zu der zweiten Aufnahme A2 zu bewegen.

Insgesamt lässt sich so jedes Bauteil B des ersten Trägers W durch entsprechende Ansteuerung der entsprechenden X-/Y-Antriebe der Fördereinrichtungen F1, F4 innerhalb eines strichzweipunktierten Bereiches AF zum Übertragen eines Bauteils B auf den zweiten Träger BM auf der zweiten Aufnahme A2 positionieren. Der strichzweipunktierte Bereich AF kann in einer Variante in Quererstreckung des zweiten Trägers BM größer sein als die Quererstreckung des zweiten Trägers BM.

Eine fünfte Fördereinrichtung F5 dient dazu, in Ansprache auf von der Steuerung ECU signalisierte Information, die erste Aufnahme A1 um einen Winkel Theta relativ zu der zweiten Aufnahme A2 zu drehen.

Eine sechste Fördereinrichtung F6 kann die zweite Aufnahme A2 gesteuert in Ansprache auf von der Steuerung ECU signalisierte Information in und gegen die Förderrichtung FR rotieren. Sie dient dazu, den zweiten Träger BM so schlupffrei und so dehnungsfrei entlang der Förderrichtung FR über die zweite Aufnahme A2 zu fördern, dass die wenigstens eine der Vielzahl elektronischer Teilbaugruppen ANT auf dem zweiten Träger BM zu der jeweiligen Ablageposition AP auf der den zweiten Träger BM führenden zweiten Aufnahme A2 gelangt.

Die Trenneinrichtung TE ist in einer Variante dazu eingerichtet ist, die Bauteile B von dem ersten Träger W berührend abzutrennen. Dazu hat sie eine Stoßnadel N, die dazu eingerichtet und dimensioniert ist, in Ansprache auf von der Steuerung ECU signalisierte Information den ersten Träger W (in Fig. 1 von oben) zu punktieren, um jeweils eines der Bauteile B von dem ersten Träger W abzulösen und auf den zweiten Träger BM zu übertragen. In einer zweiten Variante ist sie dazu eingerichtet, die Bauteile B von dem ersten Träger W berührungslos abzutrennen. Dazu hat die Trenneinrichtung TE eine steuerbare Energiequelle, die dazu eingerichtet und dimensioniert ist, in Ansprache auf von der Steuerung ECU signalisierte Information den ersten Träger W mit zum Beispiel Laser-Energie zu beschicken, um jeweils eines der Bauteile B von dem ersten Träger W abzulösen und auf den zweiten Träger BM zu übertragen.

Die zweite Aufnahme A2 ist eine kreis-zylindrische Trommel oder eine konvex gekrümmte Fläche, über die der zweite Träger BM zu der Ablageposition AP auf der zweiten Aufnahme A2 gelangt. In einer Variante hat die zweite Aufnahme A2 an ihrer den zweiten Träger BM führenden Mantel-/Oberfläche eine Vielzahl kleiner Auslässe um den zweiten Träger BM mittels Unterdruck Vak an der zweiten Aufnahme A2 schlupffrei und dehnungsfrei zu halten.

In einer Variante kann die Mantel-/Oberfläche der zweiten Aufnahme so eingerichtet sein oder der Unterdruck Vak so steuerbar ist, dass an der Mantel-/Oberfläche unterhalb der Ablageposition kein Unterdruck Vak anliegt, sondern lediglich aufstromseitig und abstromseitig von der Ablageposition AP. Somit wird aufstromseitig und abstromseitig von der Ablageposition AP der zweite Träger BM mit Unterdruck gehalten; an der Ablageposition gibt es kein Vakuum.

In einer Variante kann die zweite Aufnahme A2 mit einer Fördereinrichtung in Z-Richtung zur ersten Aufnahme A1 hin und von der ersten Aufnahme A1 weg bewegt werden, um einen Abstand zwischen der ersten und zweiten Aufnahme einzustellen.

In einer weiteren Variante kann die zweite Aufnahme A2 und/oder die dritte Aufnahme A3 na zumindest an einem Teil des jeweiligen Bereichs an dem der zweite Träger BM nicht an der jeweiligen Aufnahme A2 oder A3 anliegt, Druckluft eingebracht wird, welche durch die Öffnungen austritt, um ggf. mit der Zeit in die Vakuumlöcher eingesaugte Verschmutzungen abzublasen.

Eine dritte Inspektionseinrichtung I3 ist bezogen auf die Förderrichtung FR des zweiten Trägers BM abstromseitig zur Ablageposition AP bei der zweiten Aufnahme A2 angeordnet. Sie dient dazu, wenigstens eine der Vielzahl elektronischer Teilbaugruppen ANT auf dem zweiten Träger BM und das auf sie übertragene Bauteil B in ihrer Lage relativ zu einander zu erfassen und eine die erfasste Lage repräsentierende Information an die Steuerung ECU zu signalisieren.

Eine achte Fördereinrichtung F8 dient dazu, die zweite Inspektionseinrichtung I2 relativ zu der zweiten Aufnahme A2 und der Ablageposition AP zu fördern, um wenigstens eine Bauteil-Ablagestelle auf dem zweiten Träger BM durch die zweite Inspektionseinrichtung I2 zu erfassen. Die zweite Inspektionseinrichtung I2 ist damit sowohl in Längserstreckung der trommelförmigen zweiten Aufnahme A2, also quer zur Förderrichtung FR des zweiten Trägers BM gesteuert verfahrbar, als auch um einen vorgestimmten Winkelbetrag entlang des Umfangs an der Mantelfläche der trommelförmigen zweiten Aufnahme A2. Alternativ dazu wird der Winkel vor Betriebsaufnahme manuell eingestellt.

Auf diese Weise kann auch wenigstens eine der Vielzahl elektronischer Teilbaugruppen ANT auf dem zweiten Träger BM in ihrer Lage erfasst werden um eine die erfasste Lage repräsentierende Information an die Steuerung ECU zu signalisieren. Des weiterein ist in dieser Variante eine neunte Fördereinrichtung F9 vorgesehen, um die dritte Inspektionseinrichtung I3 relativ zu der zweiten Aufnahme A2 und der Ablageposition AP zu fördern in analoger Weise wie dies die achte Fördereinrichtung F8 für die zweite Inspektionseinrichtung I2 ausführt. Damit kann die dritte Inspektionseinrichtung I3 wenigstens eine der Vielzahl elektronischer Teilbaugruppen ANT auf dem zweiten Träger BM und das auf sie übertragene Bauteil B in ihrer Lage relativ zu einander zu erfassen und eine die erfasste Lage repräsentierende Information an die Steuerung ECU zu signalisieren.

Eine weitere (Teil-)Vorrichtung, wie sie in Fig. 1 auf der linken Seite veranschaulicht ist, dient zum Auftragen von Klebstoff K aus einem Vorrat auf einen zweiten Träger BM. Wie bereits erwähnt ist der zweite Träger BM quasi-endlos ausgestaltet und trägt in seiner Längs- und Quererstreckung eine Vielzahl elektronischer Teilbaugruppen ANT, zu denen der Klebstoff K aufzutragen ist um danach ein Bauteil B zu einer der Teilbaugruppen ANT zu übertragen. Die weitere Vorrichtung umfasst eine dritte Aufnahme A3, die dazu dient, dass über sie der zweite Träger BM entlang seiner Längserstreckung in einer Förderrichtung FR des zweiten Trägers BM zu führen ist.

Eine Spendeeinrichtung SE für Klebstoff K ist in Fig. 1 oberhalb der dritten Aufnahme A3 vorgesehen um gesteuert und dosiert Klebstoff K zu der dritten Aufnahme A3 hin auf eine Klebe-Stelle KS am zweiten Träger BM an einer Klebstoff-Ausbringposition KAP auszubringen, an der sich eine der Vielzahl elektronischer Teilbaugruppen ANT befindet.

Eine elfte Fördereinrichtung F11 dient dazu, die Spendeeinrichtung SE für Klebstoff K quer zur Förderrichtung FR des zweiten Trägers BM relativ zu der dritten Aufnahme A3 zu bewegen. Eine vierte Inspektionseinrichtung I4 ist der der dritten Aufnahme A3 zugeordnet und ist aufstromseitig zur Klebstoff-Ausbringposition KAP angeordnet. Die vierte Inspektionseinrichtung I4 dient dazu, wenigstens eine der Vielzahl elektronischer Teilbaugruppen ANT auf dem zweiten Träger BM in ihrer Lage relativ zu der dritten Aufnahme A3 zu erfassen und eine die erfasste Lage repräsentierende Information an die Steuerung ECU zu signalisieren.

Eine zwölfte Fördereinrichtung F12 ist in dieser Ausgestaltung durch zwei gesteuert anzutreibende Transportwalzen gebildet, die jeweils auf- und abstromseitig zu der trommelförmigen dritten Aufnahme A3 angeordnet sind, und um die der zweite Träger BM geführt ist. In Ansprache auf von der Steuerung ECU signalisierte Information, wird der zweite Träger BM durch die zwei gesteuert anzutreibenden Transportwalzen in seiner Lage relativ zu der Klebstoff-Ausbringposition KAP so gefördert, dass die wenigstens eine der Vielzahl elektronischer Teilbaugruppen ANT mit der Klebe-Stelle KS auf dem zweiten Träger BM zu der Klebstoff-Ausbringposition KAP auf der den zweiten Träger BM führenden dritten Aufnahme A3 gelangt.

Die Klebstoff-Ausbring-Vorrichtung wirkt in der hier gezeigten Ausgestaltung zusammen mit der Übertragungs-Vorrichtung für Bauteile von einem ersten Träger zu einem zweiten Träger. Dazu ist die Vorrichtung zum Klebstoff-Ausbringen und aufstromseitig zu der Übertragungs-Vorrichtung für Bauteile eingesetzt.

Auch bei der Vorrichtung zum Klebstoff-Ausbringen gilt, dass sie erlaubt, mehrreihiges Bandmaterial als zweiten Träger zu verwenden.

Bei der Vorrichtung wird die Klebe-Stelle auf dem Bahnmaterial räumlich / zeitlich vor dem eigentlichen Klebstoff-Ausbringen erfasst. Dabei erfasst eine vierte Inspektionseinrichtung I4 direkt, also nicht durch den zweiten Träger BM hindurch, sondern die jeweilige Klebe-Stelle KS bei der jeweiligen elektronischen Teilbaugruppe auf dem zweiten Träger BM selbst. Dann wird der zweite Träger BM so kontrolliert zu der Klebstoff-Ausbring-Position KAP gefördert, dass die Klebe-Stelle KS möglichst präzise mit der Position des Auslasses der Spendeeinrichtung SE für Klebstoff K fluchtet, wenn die Spendeeinrichtung dosiert eine Portion Klebstoff K auf die Klebe-Stelle KS ausbringt.

Die vierte Inspektionseinrichtung I4 ist - bezogen auf die Förderrichtung FR des zweiten Trägers BM - aufstromseitig zur Klebstoff-Ausbring-Position KAP am Umfang der trommelförmigen dritten Aufnahme A3 angeordnet und dient dazu, quer zur Förderrichtung FR des zweiten Trägers BM jeweils ein oder mehrere der Vielzahl elektronischer Teilbaugruppen ANT auf dem zweiten Träger BM in ihrer Lage relativ zu der dritten Aufnahme A3 zu erfassen und eine die erfasste Lage repräsentierende Information an die Steuerung ECU zu signalisieren.

Der zwölften Fördereinrichtung F12 ist eine zweite Sensoreinrichtung SE2 zugeordnet, um der Steuerung ECU Information zu Förderrichtung und Förderweg des zweiten Trägers BM relativ zu der Klebstoff-Ausbring-Position KAP zu signalisieren.

Die Steuerung ECU dient dazu, basierend auf der Information der vierten Inspektionseinrichtung I4 zur Lage der wenigstens einen elektronische Teilbaugruppe ANT und der Information zu Förderrichtung und Förderweg des zweiten Trägers BM sowie basierend auf der Information der vierten Inspektionseinrichtung I4 zur Lage wenigstens eines der Bauteile B relativ zur Klebstoff-Ausbring-Position KAP die elfte Fördereinrichtung F11 anzusteuern, um die Spendeeinrichtung SE quer zur Förderrichtung FR des zweiten Trägers BM zu bewegen. der Eine dreizehnte Fördereinrichtung F13, dient dazu, in Ansprache auf von der Steuerung ECU signalisierte Information, den zweiten Träger BM entlang der Förderrichtung FR über die dritte Aufnahme A3 zu fördern. Dies geschieht durch die Steuerung ECU gesteuert so schlupffrei und so dehnungsfrei, dass die wenigstens eine der Vielzahl elektronischer Teilbaugruppen ANT auf dem zweiten Träger BM zu der Klebstoff-Ausbring-Position KAP auf der den zweiten Träger BM führenden dritten Aufnahme A3 gelangt.

Die dritte Aufnahme A3 ist - vergleichbar zur zweiten Aufnahme A2 eine kreis-zylindrische Trommel oder eine konvex gekrümmte Fläche, über die der zweite Träger BM zu der Klebstoff-Ausbringposition KAP auf der dritten Aufnahme A3 gelangt. Auch hier hat die zweite Aufnahme an ihrer den zweiten Träger BM führenden Mantel-/Oberfläche Auslässe um den zweiten Träger BM mittels Unterdruck Vak an der dritten Aufnahme A3 schlupffrei und dehnungsfrei zu halten.

Eine fünfte Inspektionseinrichtung I5 ist bezogen auf die Förderrichtung FR des zweiten Trägers BM abstromseitig zur Klebstoff-Ausbring-Position KAP am Umfang der trommelförmigen dritten Aufnahme A3 angeordnet und dient dazu, wenigstens eine der Vielzahl elektronischer Teilbaugruppen ANT auf dem zweiten Träger BM und den auf sie ausgebrachten Klebstoff K in ihrer Lage relativ zu einander zu erfassen und eine die erfasste Lage repräsentierende Information an die Steuerung ECU zu signalisieren.

Eine vierzehnte Fördereinrichtung F14 dient dazu, die vierte Inspektionseinrichtung F4 relativ zu der dritten Aufnahme A3 und der Klebstoff-Ausbring-Position KAP zu fördern. So kann die vierte Inspektionseinrichtung F4 wenigstens eine Klebestelle KS auf dem zweiten Träger BM erfassen, um wenigstens eine der Vielzahl elektronischer Teilbaugruppen ANT auf dem zweiten Träger BM in ihrer Lage zu erfassen und eine die erfasste Lage repräsentierende Information an die Steuerung ECU zu signalisieren.

Eine fünfzehnte Fördereinrichtung F15 dient dazu, die fünfte Inspektionseinrichtung I5 relativ zu der dritten Aufnahme A3 und der Klebstoff-Ausbring-Position KAP entlang des Umfangs der dritten Aufnahme A3 zu fördern. So kann die fünfte Inspektionseinrichtung I5 wenigstens eine der Vielzahl elektronischer Teilbaugruppen ANT auf dem zweiten Träger BM und den auf sie ausgebrachten Klebstoff K in ihrer Lage relativ zu einander zu erfassen und eine die erfasste Lage repräsentierende Information an die Steuerung ECU zu signalisieren.

In besonders einfacher und vorteilhafter Weise ist der gemäß Fig. 2 in X-/Y-/Theta-Koordinaten verstellbare Tisch wie folgt ausgestaltet: Die den ersten Träger W aufnehmende Aufnahme A1 ist an einer ersten Trägerplatte angeordnet, wobei die fünfte Fördereinrichtung F5 dazu dient, die erste Aufnahme A1 um einen Winkel Theta relativ zur ersten Trägerplatte zu rotieren.

Die erste Trägerplatte ist an einer zweiten Trägerplatte in Quererstreckung (Y) des zweiten Trägers BM verschiebbar angeordnet. Die erste Fördereinrichtung F1 ist dazu vorgesehen, die erste Trägerplatte und somit auch die erste Aufnahme A1 (ausschließlich) quer zur Förderrichtung FR des zweiten Trägers BM relativ zu der zweiten Trägerplatte zu bewegen.

Die zweite Trägerplatte ist an einer starren, dritten Trägerplatte oder an einem Tragrahmen in Förderrichtung FR des zweiten Trägers BM verschiebbar angeordnet. Die vierte Fördereinrichtung F4 ist dazu vorgesehen, die erste Aufnahme W, die erste Trägerplatte und die zweite Trägerplatte (ausschließlich) in Förderrichtung FR des zweiten Trägers BM relativ zu der dritten Trägerplatte zu bewegen.

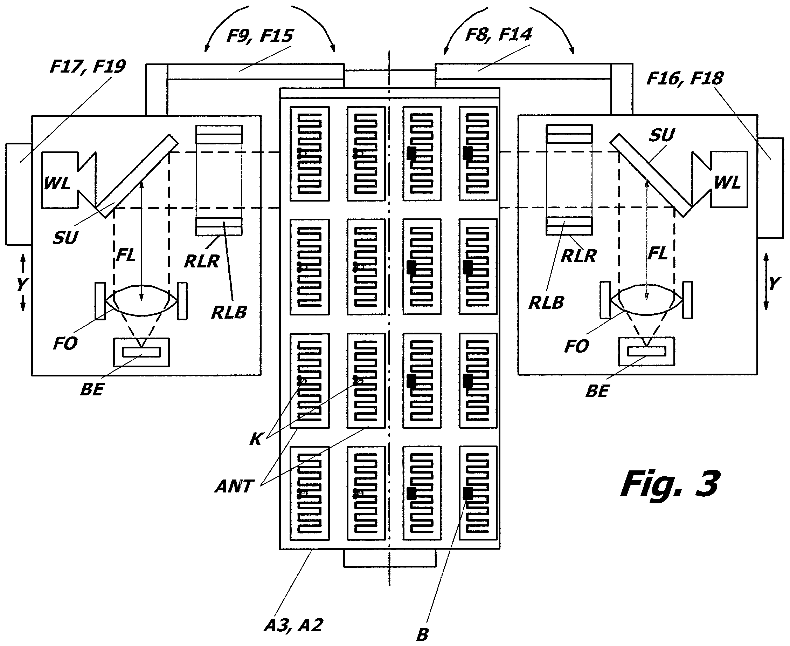

In Fig. 3 sind die zweiten bis fünften Inspektionseinrichtungen I2 ... I5 für die vorstehend beschriebenen Vorrichtungen zum Übertragen elektronischer Bauteile B von einem ersten Träger W zu einem zweiten Träger BM und zum Auftragen von Klebstoff K aus einem Vorrat auf einen zweiten Träger BM wie nachstehend beschrieben ausgestaltet.

In einer Ausgestaltung kann entweder die Bilderfassungseinrichtung BE (Kamera) bei den Inspektionseinrichtungen I2 ... I5 in Y-Richtung verschoben werden. In dieser Variante kann die Strahlumlenkung entfallen. Alternativ kann die restliche Optik umfassend eine Fokussieroptik, Strahlumlenkung und/oder Beleuchtung in Y-Richtung bewegt werden, während die Kamera ortsfest bleibt, und nicht in Y-Richtung bewegt wird. Bei dieser Variante wird die Kamera nur im Winkel über den Schwenkarm eingestellt wird.

Einer Bilderfassungseinrichtung BE in Gestalt einer Kamera ist eine Beleuchtungseinrichtung WL, RLB, BLB zugeordnet. Die Beleuchtungseinrichtung WL, RLB, BLB hat eine Weiß-Licht-WL, eine Infra-Rot-Licht- RLR, und eine Blau-Licht-Quelle RLB. Die Beleuchtungseinrichtung WL, RLB, BLB dient dazu, Licht unterschiedlicher Wellenlänge auf die zweite Aufnahme A2 zu richten. Damit können unterschiedliche Details der Bauteile / der Teilbaugruppen, des Klebers von der Bilderfassungseinrichtung BE bildlich erfasst werden, die auf den zweiten Träger BM gerichtet ist.

Eine sechzehnte, siebzehnte, achtzehnte und/oder neunzehnte Fördereinrichtung F16 ... F19 ist jeweils dazu eingerichtet, die jeweilige Bilderfassungseinrichtung BE mit der ihr zugeordneten Beleuchtungseinrichtung WL, RLB, BLB entlang der zweiten bzw. dritten Aufnahme A2 A3, sprich quer zur Förderrichtung des zweiten Trägers BM zu fördern. Mit anderen Worten sind sechzehnte, siebzehnte, achtzehnte und/oder neunzehnte Fördereinrichtung F16 ... F19 y-Antriebe, und achte, neunte, vierzehnte und/oder fünzehnte Fördereinrichtung F8, F9, F14, F15 motorische Schwenkarme vorgesehen, deren Funktion auch manuell erfüllt werden kann.

Die achte, neunte, vierzehnte, und fünfzehnte Fördereinrichtung F8, F9, F14, F15 dienen dazu, die jeweilige zweite, dritte, vierte und/oder fünfte Inspektionseinrichtung I2 ... I5 relativ zu der jeweilige zweiten und/oder dritten Aufnahme A2, A3 und der Bauteil-Ablageposition AP oder der Klebstoff-Ausbring-Position KAP entlang der Förderrichtung FR des zweiten Träger BM zu fördern. Dadurch kann die jeweilige zweite, dritte, vierte und/oder fünfte Inspektionseinrichtung I2 ... I5 vorteilhaft an unterschiedliche Abstände elektronischer Teilbaugruppen auf dem zweiten Träger angepasst werden.

In der gezeigten Variante der Beleuchtungseinrichtung WL, RLB, BLB sind die Infra-Rot-Licht-RLR, und die Blau-Licht-Quelle RLB als Ringlichtquelle ausgestaltet, die einen Erfassungsbereich EB der Bilderfassungseinrichtung BE umgeben. Die Weiß-Licht-Quelle WL ist auf einer von dem Erfassungsbereich EB der Bilderfassungseinrichtung BE abliegenden Seite einer teilweise licht-durchlässigen Strahlumlenkung SU in Gestalt eines 45°-Spiegels angeordnet. Die Bilderfassungseinrichtung BE hat jeweils eine Fokussieroptik FO, die einen fest einstellbaren Abstand FL zur ihr zugewandten Seite einer zumindest teilweise lichtdurchlässigen Strahlumlenkung SU angeordnet ist.

## Patentansprüche

1. Inspektionseinrichtung (I2 ... I5) zur Verwendung in einer Vorrichtungen zum Übertragen elektronischer Bauteile (B) von einem ersten Träger (W) zu einem zweiten Träger (BM) und/oder zum Auftragen von Klebstoff aus einem Vorrat auf einen zweiten Träger (BM) mit
- einer Bilderfassungseinrichtung, der
- eine Beleuchtungseinrichtung (WL, RLB, BLB) zugeordnet ist, wobei die Beleuchtungseinrichtung (WL, RLB, BLB) dazu eingerichtet ist, Licht unterschiedlicher Wellenlänge auf eine zweite Aufnahme (A2) zu richten, die dazu eingerichtet ist, ein auf dem zweiten Träger (BM) befindliches Objekt zu tragen, das von der Bilderfassungseinrichtung aufzunehmen ist, wobei
- eine sechzehnte, siebzehnte, achtzehnte und/oder neunzehnte Fördereinrichtung (F16 ... F19) dazu eingerichtet ist, die jeweilige Bilderfassungseinrichtung und/oder die ihr zugeordnete Optik umfassend eine Fokussieroptik, Strahlumlenkung und/oder Beleuchtungseinrichtung (WL, RLB, BLB) entlang der zweiten Aufnahme zu fördern.

2. Inspektionseinrichtung (I2 ... I5) nach Anspruch 1, bei der
- eine achte, neunte, vierzehnte, und/oder fünfzehnte Fördereinrichtung (F8, F9, F14, F15), dazu vorgesehen und eingerichtet ist, die jeweilige zweite, dritte, vierte und/oder fünfte Inspektionseinrichtung relativ zu der jeweilige zweiten und/oder dritten Aufnahme (AN2, AN3) und der Bauteil-Ablageposition oder einer Klebstoff-Ausbring-Position entlang der Förderrichtung des zweiten Trägers (BM) zu fördern.

3. Inspektionseinrichtung (I2 ... I5) nach Anspruch 1 oder 2, bei der
- die Beleuchtungseinrichtung (WL, RLB, BLB) eine Weiß-Licht-, eine (Infra-)Rot-Licht-, und/oder eine Blau-Licht-Quelle umfasst, und/oder bei der
in der Beleuchtungseinrichtung (WL, RLB, BLB)
- die (Infra-)Rot-Licht-, und/oder die Blau-Licht-Quelle als Ringlichtquelle ausgestaltet sind, die einen Erfassungsbereich der Bilderfassungseinrichtung zumindest teilweise umgibt.

4. Inspektionseinrichtung (I2 ... I5) nach einem der Ansprüche 1 - 3, bei der in der Beleuchtungseinrichtung (WL, RLB, BLB)
- die Weiß-Licht-Quelle auf einer von dem Erfassungsbereich der Bilderfassungseinrichtung abliegenden Seite einer zumindest teilweise licht-durchlässigen Strahlumlenkung angeordnet ist.

5. Inspektionseinrichtung (I2 ... I5) nach einem der Ansprüche 1 - 4, bei der
- die Bilderfassungseinrichtung eine Fokussieroptik umfasst, die einen fest einstellbaren Abstand zur ihr zugewandten Seite einer zumindest teilweise Lichtdurchlässigen Strahlumlenkung angeordnet ist.

6. Inspektionseinrichtung (I2....5) nach einem der Ansprüche 1 - 5, bei der
- die zweite und/oder dritte Aufnahme (A2, A3) an ihrer den zweiten Träger führenden Mantel-/Oberfläche Auslässe aufweist, die dazu eingerichtet sind, den zweiten Träger mittels Unterdruck an der zweiten und/oder dritten Aufnahme (A2, A3) zu halten.

7. Inspektionseinrichtung (I2....I5) nach einem der Ansprüche 1 - 6, bei der
- eine achte, neunte, vierzehnte, und/oder fünfzehnte Fördereinrichtung (F8, F9, F14, F15), vorgesehen und eingerichtet ist, die jeweilige zweite, dritte, vierte und/oder fünfte Inspektionseinrichtung relativ zu der jeweiligen zweiten und/oder dritten Aufnahme (A2, A3) und der Bauteil-Ablageposition oder der Klebstoff-Ausbring-Position entlang der Förderrichtung des zweiten Trägers zu fördern, oder bei der
- jeweils ein Schwenkarm vorgesehen und eingerichtet ist, die jeweilige zweite, dritte, vierte und/oder fünfte Inspektionseinrichtung relativ zu der jeweiligen zweiten und/oder dritten Aufnahme (A2, A3) und der Bauteil-Ablageposition oder der Klebstoff-Ausbring-Position entlang der Förderrichtung des zweiten Trägers zu verstellen.

8. Verfahren zur Inspektion mittels einer Inspektionseinrichtung (I2 ... I5), die zu einer Verwendung in einer Vorrichtungen zum Übertragen elektronischer Bauteile (B) von einem ersten Träger (W) zu einem zweiten Träger (BM) und/oder zum Auftragen von Klebstoff aus einem Vorrat auf einen zweiten Träger (BM) bestimmt ist, mit den Schritten:
- Bereitstellen einer Bilderfassungseinrichtung, der
- eine Beleuchtungseinrichtung (WL, RLB, BLB) zugeordnet ist, wobei die Beleuchtungseinrichtung (WL, RLB, BLB) dazu eingerichtet ist, Licht unterschiedlicher Wellenlänge auf eine zweite Aufnahme (A2) zu richten, die dazu eingerichtet ist, ein auf dem zweiten Träger (BM) befindliches Objekt zu tragen, das von der Bilderfassungseinrichtung aufzunehmen ist,
- Bereitstellen einer sechzehnten, siebzehnten, achtzehnten und/oder neunzehnten Fördereinrichtung (F16 ... F19), die dazu eingerichtet ist, die jeweilige Bilderfassungseinrichtung und/oder die ihr zugeordnete Optik umfassend eine Fokussieroptik, Strahlumlenkung und/oder Beleuchtungseinrichtung (WL, RLB, BLB) entlang der zweiten Aufnahme zu fördern.

## Claims

1. An inspection unit (I2 ... I5) for use in a device for transferring electronic components (B) from a first substrate (W) to a second substrate (BM) and/or for applying adhesive from a reservoir to a second substrate (BM) with
- an image capturing unit, with which
- an illumination unit (WL, RLB, BLB) is associated, wherein the illumination unit (WL, RLB, BLB) is designed to direct light of different wavelengths onto a second holder (A2), which is designed to support an object located on the second substrate (BM) that is to be captured by the image capturing unit, wherein
- a sixteenth, seventeenth, eighteenth and/or nineteenth conveying unit (F16 ... F19) is designed to convey the respective image capturing unit and/or its associated optics, comprising focusing optics, beam deflector and/or illumination unit (WL, RLB, BLB), along the second holder.

2. The inspection unit (I2 ... I5) according to Claim 1, in which
- an eighth, ninth, fourteenth and/or fifteenth conveying unit (F8, F9, F14, F15) is provided and designed to convey the respective second, third, fourth and/or fifth inspection unit relative to the respective second and/or third holder (AN2, AN3) and the component assembly position or an adhesive application position along the conveying direction of the second substrate (BM).

3. The inspection unit (I2 ... I5) according to Claim 1 or 2, in which
- the illumination unit (WL, RLB, BLB) comprises a white light source, an (infra-)red light source and/or a blue light source, and/or in which
in the illumination unit (WL, RLB, BLB)
- the (infra-)red light source and/or the blue light source are configured as a ring light source, which at least partially encloses a capture area of the image capturing unit.

4. The inspection unit (I2 ... I5) according to any one of Claims 1 - 3, in which in the illumination unit (WL, RLB, BLB)
- the white light source is arranged on a side, remote from the capture area of the image capturing unit, of an at least partially light-permeable beam deflector.

5. The inspection unit (I2 ... I5) according to any one of Claims 1 - 4, in which
- the image capturing unit comprises focusing optics, which are arranged at a distance, which can be fixedly set, from the side facing them of an at least partially light-permeable beam deflector.

6. The inspection unit (I2 ... I5) according to any one of Claims 1 - 5, in which
- the second and/or third holder (A2, A3) has on its shell/surface carrying the second substrate outlets that are designed to hold the second substrate on the second and/or third holder (A2, A3) by means of a vacuum.

7. The inspection unit (I2 ... I5) according to any one of Claims 1 - 6, in which
- an eighth, ninth, fourteenth and/or fifteenth conveying unit (F8, F9, F14, F15) are provided and designed to convey the respective second, third, fourth and/or fifth inspection unit relative to the respective second and/or third holder (A2, A3) and the component assembly position or the adhesive application position along the conveying direction of the second substrate, or in which
- a pivot arm is respectively provided and designed to adjust the respective second, third, fourth and/or fifth inspection unit relative to the respective second and/or third holder (A2, A3) and the component assembly position or the adhesive application position along the conveying direction of the second substrate.

8. A method for inspection by means of an inspection unit (I2 ... I5), which is intended for use in a device for transferring electronic components (B) from a first substrate (W) to a second substrate (BM) and/or for applying adhesive from a reservoir to a second substrate (BM) with the steps:
- provision of an image capturing unit, with which
- an illumination unit (WL, RLB, BLB) is associated, wherein the illumination unit (WL, RLB, BLB) is designed to direct light of different wavelengths onto a second holder (A2), which is designed to support an object located on the second substrate (BM) that is to be captured by the image capturing unit,
- provision of a sixteenth, seventeenth, eighteenth and/or nineteenth conveying unit (F16 ... F19), which is designed to convey the respective image capturing unit and/or its associated optics, comprising focusing optics, beam deflector and/or illumination unit (WL, RLB, BLB), along the second holder.

## Revendications

1. Un dispositif d'inspection (I2 ... I5) destiné à être utilisé dans un dispositif pour transférer des composants électroniques (B) d'un premier support (W) à un second support (BM) et/ou pour appliquer de la colle d'une réserve à un second support (BM), comprenant
- d'un dispositif d'acquisition d'images, le
- un dispositif d'éclairage (WL, RLB, BLB) est associé, la
des moyens d'éclairage (WL, RLB, BLB) sont adaptés pour diriger de la lumière de différentes longueurs d'onde sur un deuxième logement (A2) qui est adapté pour porter un objet se trouvant sur le deuxième support (BM) qui doit être pris par les moyens de capture d'image, dans lequel
- un seizième, dix-septième, dix-huitième et/ou dix-neuvième dispositif de transport (F16 ... F19) est conçu pour transporter le dispositif d'acquisition d'image respectif et/ ou l'optique qui lui est associée comprenant une optique de focalisation, une déviation de faisceau et/ou un dispositif d'éclairage (WL, RLB, BLB) le long du deuxième logement.

2. Le dispositif d'inspection (I2 ... I5) selon la revendication 1, dans lequel
- un huitième, neuvième, quatorzième et/ou quinzième dispositif de transport (F8, F9, F14, F15) est prévu et agencé pour transporter le deuxième, troisième, quatrième et/ ou cinquième dispositif d'inspection respectif par rapport au deuxième et/ou troisième réceptacle respectif (AN2, AN3) et la position de dépôt de composant ou une position de distribution d'adhésif le long de la direction de transport du deuxième support (BM).

3. Le dispositif d'inspection (I2 ... I5) selon la revendication 1 ou 2, dans lequel
- le dispositif d'éclairage (WL, RLB, BLB) comprend une source de lumière blanche, une source de lumière (infra)rouge, et/ou une source de lumière bleue, et/ou dans lequel
dans le dispositif d'éclairage (WL, RLB, BLB)
- la source de lumière (infra)rouge et/ou la source de lumière bleue sont conçues comme une source de lumière annulaire qui entoure au moins partiellement une zone de détection du dispositif de détection d'image.

4. Le dispositif d'inspection (12 ... 15) selon l'une des revendications 1 à 3, dans lequel, dans le dispositif d'éclairage (WL, RLB, BLB)
- la source de lumière blanche est disposée sur un côté, éloigné de la zone de détection du dispositif de saisie d'image, d'une déviation de faisceau au moins partiellement transparente à la lumière.

5. Le dispositif d'inspection (I2 ... I5) selon l'une des revendications 1 à 4, dans lequel
- le dispositif d'acquisition d'image comprend une optique de focalisation qui est disposée à une distance réglable de manière fixe par rapport au côté qui lui fait face d'une déviation de faisceau au moins partiellement transparente.

6. Le dispositif d'inspection (I2 ... I5) selon l'une quelconque des revendications 1 à 5, dans lequel
- le deuxième et/ou troisième logement (A2, A3) présente sur son enveloppe/surface guidant le deuxième support des sorties qui sont conçues pour maintenir le deuxième support par pression sur le deuxième et/ou troisième logement (A2, A3).

7. Le dispositif d'inspection (I2 ... I5) selon l'une quelconque des revendications 1 à 6, dans lequel
- un huitième, neuvième, quatorzième et/ou quinzième dispositif de transport (F8, F9, F14, F15) est prévu et agencé pour transporter le deuxième, troisième, quatrième et/ ou cinquième dispositif d'inspection respectif par rapport au deuxième et/ou troisième logement respectif (A2, A3) et à la position de dépose de composant ou à la position de distribution de colle le long de la direction de transport du deuxième support, ou lors de la
- un bras pivotant est respectivement prévu et aménagé pour déplacer le deuxième, le troisième, le quatrième et/ou le cinquième dispositif d'inspection respectif par rapport au deuxième et/ou au troisième logement (A2, A3) respectif et à la position de dépose de composant ou à la position de distribution de colle le long de la direction de transport du deuxième support.

8. Le dispositif d'inspection au moyen d'un dispositif d'inspection (I2 ... I5) destiné à être utilisé dans un dispositif pour transférer des composants électroniques (B) d'un premier support (W) à un second support (BM) et/ou pour appliquer un adhésif à partir d'une réserve sur un second support (BM), comprenant les étapes consistant à :
- Fournir un dispositif de capture d'image, le
- un dispositif d'éclairage (WL, RLB, BLB) est associé, le dispositif d'éclairage (WL, RLB, BLB) étant adapté pour diriger de la lumière de différentes longueurs d'onde sur un deuxième logement (A2) qui est adapté pour porter un objet se trouvant sur le deuxième support (BM) qui doit être pris par le dispositif de capture d'image,
- la mise à disposition d'un seizième, dix-septième, dix-huitième et/ou dix-neuvième dispositif de transport (F16 ... F19), qui est conçu pour transporter le dispositif d'acquisition d'image respectif et/ou l'optique qui lui est associée, comprenant une optique de focalisation, une déviation de faisceau et/ou un dispositif d'éclairage (WL, RLB, BLB) le long du deuxième logement.
